# EUROPEAN PATENT APPLICATION

(11) **EP 4 712 082 A1**
(43) Date of publication of application: **18.03.2026**
(21) Application number: 25201789.2
(22) Date of filing: 12.09.2025
(51) Int. Cl.: G11C 29/02, G11C 29/12, G11C 29/32, G11C 29/48, G11C 29/00, G01R 31/28, H01L 21/66

(54) **SEMICONDUCTOR DEVICE INCLUDING FAULT DETECTION CIRCUIT**

(30) Priority: 13.09.2024 KR 20240126045
(71) Applicant: SAMSUNG ELECTRONICS CO., LTD., Yeongtong-gu Suwon-si, Gyeonggi-do 16677 (KR)
(72) Inventor: JUNG, Sang-Hoon, 16677 Suwon-si, Gyeonggi-do (KR); PARK, Young Seok, 16677 Suwon-si, Gyeonggi-do (KR); SEO, Younghun, 16677 Suwon-si, Gyeonggi-do (KR); YOON, Hyun-Chul, 16677 Suwon-si, Gyeonggi-do (KR)
(74) Representative: Kuhnen & Wacker Patent- und Rechtsanwaltsbüro PartG mbB

(57) **Abstract**

A semiconductor device includes a first structure (100) including first test pads (TP1), a second structure (200) disposed on the first structure (100) and including second test pads (TP2) that respectively correspond to the first test pads (TP1) and form a test pad chain (TPC) with the first test pads (TP1), a first terminal connected to one end of the test pad chain (TPC), a plurality of fault detection circuits (FDC) connected to the test pad chain (TPC) to detect a connection status of the test pad chain (TPC), and a second terminal connected to the other end of the test pad chain (TPC).

## Description

### BACKGROUND

Semiconductor devices are used to store data and classified into volatile memory devices and nonvolatile memory devices. A volatile memory device is a memory device that loses its stored data when the power supply is interrupted. Among volatile memory devices, dynamic random access memory (DRAM) is used in various fields, such as a mobile system, a server, a graphics unit, etc.

In response to the demand for high integration in semiconductor devices, semiconductor devices with a stacked structure are being developed. As an example, a semiconductor device with a Cell over Peripheral (CoP) structure is being developed, where memory cells to store data and circuits to drive the memory cells are implemented on separate wafers and then stacked.

### SUMMARY

Implementations of the present disclosure provide a semiconductor device with a CoP structure, which is able to easily detect faults in bonding pads.

According to an implementation, a semiconductor device includes a first structure including first test pads, a second structure disposed on the first structure and including second test pads corresponding to the first test pads, respectively, and forming a test pad chain with the first test pads, a first terminal connected to one end of the test pad chain, a plurality of fault detection circuits connected to the test pad chain to detect a connection status of the test pad chain, and a second terminal connected to the other end of the test pad chain.

According to an implementation, a semiconductor device includes a first structure including first test pads, a second structure disposed on the first structure and including second test pads corresponding to the first test pads, respectively, and forming a test pad chain with the first test pads, a first terminal connected to one end of the test pad chain, a plurality of fault detection circuits connected to the test pad chain to detect a connection status of the test pad chain, and a second terminal connected to the other end of the test pad chain. Each of the fault detection circuits includes a data input circuit configured to change a voltage level at a predetermined node based on whether the data input circuit receives a test input signal according to whether a fault occurs in the test pad chain, a data path circuit configured to store the voltage level at the node as data depending on whether the test input signal is received, and a data reset circuit connected to the node and configured to reset the voltage level at the node.

According to the above, the semiconductor device with a CoP structure is capable of detecting faults in the bonding pads and identifying the location of the faults with ease.

### BRIEF DESCRIPTION OF THE FIGURES

The above and other objects and features of the present disclosure will become apparent by describing in detail implementations thereof with reference to the accompanying drawings.
FIG. 1 is a conceptual view illustrating a semiconductor device according to an implementation of the present disclosure;
FIG. 2 is a cross-sectional view taken along a line A-A' of FIG. 1;
FIG. 3 is a plan view illustrating a test pad chain and a plurality of fault detection circuits electrically connected to a corresponding test pad chain according to an implementation of the present disclosure;
FIG. 4 is a circuit diagram illustrating an example of a fault detection circuit of FIG. 3;
FIGS. 5A and 5B are views illustrating an example of an operation of a fault detection circuit chain of FIGS. 3 and 4;
FIGS. 6A and 6B are views illustrating an example of an operation of a fault detection circuit chain of FIGS. 3 and 4;
FIG. 7 is a cross-sectional view illustrating an example of a semiconductor device taken along a line A-A' of FIG. 1 according to an implementation of the present disclosure;
FIG. 8A is a conceptual view illustrating a portion of a semiconductor device according to an implementation of the present disclosure;
FIG. 8B is a plan view illustrating the semiconductor device of FIG. 8A;
FIGS. 9A and 9B are plan views schematically illustrating connection structures of test pad chains according to implementations of the present disclosure;
FIG. 10 is a view illustrating a memory cell array of a semiconductor memory device according to an implementation of the present disclosure; and
FIG. 11 is a cross-sectional view illustrating a semiconductor memory device according to an implementation of the present disclosure.

### DETAILED DESCRIPTION

Below, implementations of the present disclosure will be described in detail and clearly to such an extent that an ordinary one in the art easily implements the disclosure.

In addition, expressions such as "first," "second," and the like used in the present disclosure describe various components regardless of their order and/or importance, and the expressions are used only to distinguish one component from another component and do not limit the order of importance of the components.

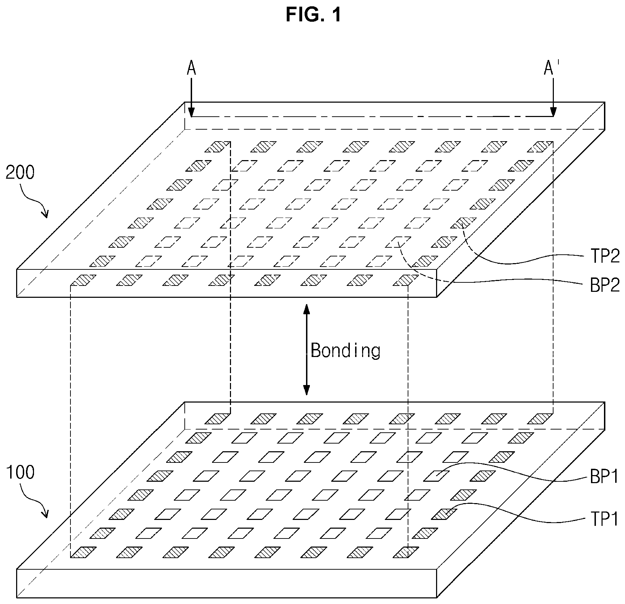

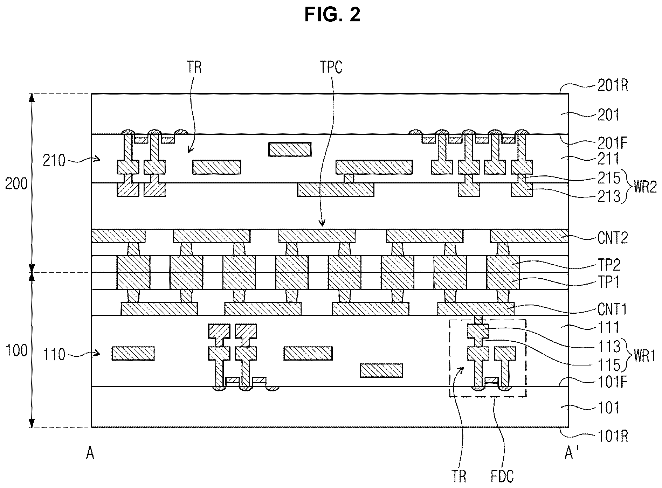

FIG. 1 is a conceptual view illustrating a semiconductor device according to an implementation of the present disclosure, and FIG. 2 is a cross-sectional view taken along a line A-A' of FIG. 1.

Referring to FIGS. 1 and 2, the semiconductor device may include a first structure 100 and a second structure 200. The semiconductor device may have a structure in which the first structure 100 and the second structure 200 are stacked one on another.

Each of the first structure 100 and the second structure 200 may be provided in the form of a chip or die. When each of the first structure 100 and the second structure 200 is provided in the chip form, the semiconductor device may have a chip-to-chip (C2C) structure. The C2C structure may be obtained by manufacturing the first structure 100 and the second structure 200 separately and connecting the first structure 100 and the second structure 200 using a bonding method. The bonding method may indicate a method of electrically or physically connecting conductive pads formed at an uppermost position in the first structure 100 and conductive pads formed at an uppermost position in the second structure 200. Each of the first structure 100 and the second structure 200 may include bonding pads to bond the first structure 100 to the second structure 200

The semiconductor device may further include test pads to test whether the bonding pads are connected, a test pad chain TPC including the test pads, and a plurality of fault detection circuits FDC connected to the test pad chain TPC.

Hereinafter, the first structure 100 and the second structure 200 will be described in detail.

The first structure 100 may include a first substrate 101, a first circuit layer 110, first bonding pads BP1, and first test pads TP1.

The first substrate 101 may include a front surface 101F and a rear surface 101R.

The first substrate 101 may include various materials. As an example, the first substrate 101 may be a doped or undoped silicon (Si) substrate. According to an implementation, the first substrate 101 may include other semiconductor materials, such as germanium, a compound semiconductor, such as silicon carbide, gallium arsenide, gallium phosphide, indium phosphide, indium arsenide compounds, and/or indium antimony compounds, a hybrid semiconductor including SiGe, GaAsP, AlInAs, AlGaAs, GaInAs, GaInP and/or GaInAsP, or a combination thereof. The first substrate 101 may have a single-layer or multi-layer structure.

The first circuit layer 110 may be disposed in the first substrate 101 and/or on the first substrate 101, and for example, the first circuit layer 110 may be disposed on the front surface 101F of the first substrate 101.

The first circuit layer 110 may include transistors TR provided on the front surface 101F of the first substrate 101 and a first wiring layer WR1 provided on the front surface 101F of the first substrate 101 to cover the transistors TR. The first wiring layer WR1 may include first wirings 113 and first contact plugs 115, which are disposed in inter-layer insulating layers 111.

According to an implementation, the first circuit layer 110 may include a variety of circuits, for example, core circuits and peripheral circuits of memory devices. The core circuits may include, for example, a sub-word line driver, a bit-line sense amplifier, a row decoder(or an X-decoder), and a column decoder (or a Y-decoder). The peripheral circuits may include various circuits for decoding commands and controlling input/output of addresses and data. As an example, the peripheral circuits may include control logics, address buffers, delay-locked loops (DLLs), data input/output buffers, power circuits, etc. In the present implementation, the power circuit may be a circuit that generates various DC voltages required for the operation of the semiconductor device.

In addition, the first circuit layer 110 may include the fault detection circuits FDC electrically connected to the test pad chain TPC described later.

However, the first circuit layer 110 should not be limited thereto or thereby, and the first circuit layer 110 may include various microelectronic devices. As an example, the microelectronic devices may include active devices, passive devices, combinations of active and passive devices, circuits formed from combinations thereof, etc. The first circuit layer 110 may include, for example, an application processor (AP), a micro-processor, a central processing unit (CPU), a controller, a graphics processor unit (GPU), or an application specific integrated circuit (ASIC).

The first wiring layer WR1 may be formed of various conductive materials, such as tungsten, cobalt, nickel, copper, silver, gold, tin, molybdenum, zinc, platinum, aluminum, or combinations thereof.

The first wiring layer WR1 may have a single-layer structure or a multi-layer structure of two or more layers. For example, the first wiring layer WR1 may be formed of a single layer, two layers, or three or more layers.

The inter-layer insulating layers 111 may include dielectric materials such as silicon oxide, silicon nitride, silicon oxynitride, silicon carbide, and combinations thereof.

The first bonding pads BP1 and the first test pads TP1 may be disposed on the first substrate 101.

The first bonding pads BP1 and the first test pads TP1 may be disposed on the front surface 101F of the first substrate 101. Upper surfaces of each of the first bonding pads BP1 and the first test pads TP1 may form an uppermost surface of the first structure 100. The first bonding pads BP1 and the first test pads TP1 may be disposed in an uppermost inter-layer insulating layer among the inter-layer insulating layers 111 of the first structure 100.

The first bonding pads BP1 and the first test pads TP1 may include copper.

However, a material for the first bonding pads BP1 and the first test pads TP1 should not be limited thereto or thereby, and the first bonding pads BP1 and the first test pads TP1 may include other conductive materials. According to an implementation, each of the first bonding pads BP1 and the first test pads TP1 may include a conductive material, such as tungsten, cobalt, nickel, copper, silver, gold, tin, molybdenum, zinc, platinum, aluminum, or a combination thereof. According to an implementation, each of the first bonding pads BP1 and the first test pads TP1 may include copper, tungsten, or aluminum.

The first test pads TP1 may be manufactured through the same process as the first bonding pads BP1. In this case, the first test pads TP1 may include the same material as the first bonding pads BP1. In addition, the upper surface of the first test pads TP1 may be positioned at the same level as the upper surface of the first bonding pads BP1.

The first test pads TP1 may be connected to each other by first connection lines CNT1. Each of the first connection lines CNT1 may connect the first test pads TP1 adjacent to each other among the first test pads TP1.

The second structure 200 may include a second substrate 201, a second circuit layer 210, second bonding pads BP2, and second test pads TP2.

The second substrate 201 may include a front surface 201F and a rear surface 201R. The front surface 101F of the first substrate 101 and the front surface 201F of the second substrate may be disposed to face each other.

The second circuit layer 210, the second bonding pads BP2, and the second test pads TP2 may be provided on the front surface 201F of the second substrate 201. Since the front surface 201F of the second substrate 201 is disposed to face the front surface 101F of the first substrate 101, the second bonding pads BP2 may be bonded to the first bonding pads BP1, and the second test pads TP2 may be bonded to the first test pads TP1.

The second substrate 201 may also include various materials. The first substrate 101 and the second substrate 201 may include the same material as each other or may include different materials from each other. As an example, the second substrate 201 may be a doped or undoped silicon (Si) substrate. According to an implementation, the second substrate 201 may include other semiconductor materials, such as germanium, a compound semiconductor, such as silicon carbide, gallium arsenide, gallium phosphide, indium phosphide, indium arsenide compounds, and/or indium antimony compounds, a hybrid semiconductor including SiGe, GaAsP, AlInAs, AlGaAs, GaInAs, GaInP and/or GaInAsP, or a combination thereof. The second substrate 201 may have a single-layer or multi-layer structure.

The second circuit layer 210 may include transistors TR disposed on the front surface 201F of the second substrate 201 and a second wiring layer WR2 disposed on the front surface 201F of the second substrate 201 to cover the transistors TR. The second wiring layer WR2 may include second wirings 213 and second contact plugs 215, which are disposed in inter-layer insulating layers 211.

According to an implementation, the second circuit layer 210 may include memory cells. As an example, the second circuit layer 210 may include a dynamic random access memory (DRAM), however, the type of memory cells should not be limited thereto or thereby. According to an implementation, the second circuit layer 210 may include memory cells such as a static random access memory (SRAM), a flash memory, a phase-change random access memory (PRAM), a magneto-resistive random access memory (MRAM), a ferroelectric random access memory (FeRAM), or a resistive random access memory (RRAM).

However, the second circuit layer 210 should not be limited thereto or thereby, and the second circuit layer 210 may include various microelectronic devices different from the memory cells. As an example, the second circuit layer 210 may include microelectronic devices such as a system large-scale integration (system LSI), a CMOS imaging sensor (CIS), or the like.

The second wiring layer WR2 may be formed of various conductive materials, such as tungsten, cobalt, nickel, copper, silver, gold, tin, molybdenum, zinc, platinum, aluminum, or combinations thereof.

The second wiring layer WR2 may have a single-layer structure or a multi-layer structure of two or more layers but it should not be limited thereto or thereby. For example, the second wiring layer WR2 may be formed on a single layer, two layers, or four or more layers.

The inter-layer insulating layer 211 may include dielectric materials such as silicon oxide, silicon nitride, silicon oxynitride, silicon carbide, and combinations thereof.

The second bonding pads BP2 and the second test pads TP2 may be disposed on the second substrate 201. The second bonding pads BP2 and the second test pads TP2 may be disposed on the front surface 201F of the second substrate 201. Upper surfaces of each of the second bonding pads BP2 and the second test pads TP2 may form an uppermost surface of the second structure 200. As an example, each of the second bonding pads BP2 and the second test pads TP2 may be disposed in an uppermost inter-layer insulating layer among the inter-layer insulating layers 211 of the second structure 200.

The second bonding pads BP2 may be provided in the same number as the first bonding pads BP1 and may be provided in positions facing the first bonding pads BP1. One of the second bonding pads BP2 may be bonded to a corresponding first bonding pad among the first bonding pads BP1.

The second bonding pads BP2 and the second test pads TP2 may include copper. In the present implementation, each of the first bonding pads BP1 and the second bonding pads BP2 may include copper, and in this case, each of the first bonding pads BP1 and the second bonding pads BP2 may have a copper-to-copper (Cu-to-Cu) bonding structure.

However, a material for the second bonding pads BP2 and the second test pads TP2 should not be limited thereto or thereby, and the second bonding pads BP2 and the second test pads TP2 may include other conductive materials. According to an implementation, each of the second bonding pads BP2 and the second test pads TP2 may include a conductive material, such as tungsten, cobalt, nickel, copper, silver, gold, tin, molybdenum, zinc, platinum, aluminum, or a combination thereof. According to an implementation, each of the second bonding pads BP2 and the second test pads TP2 may include copper, tungsten, or aluminum.

The second test pads TP2 may be manufactured through the same process as the second bonding pads BP2. In this case, the second test pads TP2 may include the same material as the second bonding pads BP2. In addition, the upper surface of the second test pads TP2 may be positioned at the same level as the upper surface of the second bonding pads BP2.

The second test pads TP2 may be connected to each other by second connection lines CNT2. Each of the second connection lines CNT2 may connect the second test pads TP2 adjacent to each other among the second test pads TP2.

The first test pads TP1, the first connection lines CNT1, the second test pads TP2, and the second connection lines CNT2 may form the test pad chain TPC. The test pad chain TPC may be used to test whether the first bonding pads BP1 and the second bonding pads BP2 are bonded. The bonding status of the first bonding pads BP1 and the second bonding pads BP2 may be identified by inspecting the bonding status of the first and second test pads TP1 and TP2.

The first test pads TP1 and the second test pads TP2 may be connected by the first connection lines CNT1 and the second connection lines CNT2, respectively, to form the test pad chain TPC. In detail, each of the first connection lines CNT1 may connect a pair of the first test pads TP1 placed adjacent to each other among the first test pads TP1, but the first connection lines CNT1 may not consecutively connect all of the first test pads TP1. In addition the second connection lines CNT2 may connect a pair of the second test pads TP2 placed adjacent to each other among the second test pads TP2, but the second connection lines CNT2 may not consecutively connect all of the second test pads TP2.

As an example, when the first test pads TP1 are sequentially arranged, each first connection line CNT1 may connect an odd-numbered first test pad TP1 to the next even-numbered first test pad TP1 arranged in order. Each first connection line CNT1 may not connect an even-numbered first test pad TP1 to the next odd-numbered first test pad TP1 arranged in order. In addition, when the second test pads TP2 are sequentially arranged, each second connection line CNT2 may connect an even-numbered second test pad TP2 to the next odd-numbered second test pad TP2 arranged in order. Each second connection line CNT2 may not connect an odd-numbered second test pad TP2 to the next even-numbered second test pad TP2 arranged in order.

In this way, each first connection line CNT1 may connect a (2p-1)th (p is a natural number) first test pad TP1 to a 2p-th first test pad TP1, and each second connection line CNT2 may connect a 2p-th second test pad TP2 to a (2p+1)th second test pad TP2.

Consequently, the first test pads TP1 and the second test pads TP2 may be connected in series by the first connection lines CNT1 and the second connection lines CNT2, and the first test pads TP1, the second test pads TP2, the first connection lines CNT1, and the second connection lines CNT2, which are connected to each other in series, may form the test pad chain TPC.

The fault detection circuits FDC may be connected to the test pad chain TPC to identify the occurrence of faults in the test pad chain TPC. The fault detection circuits FDC may be connected to corresponding pads of the first test pads TP1 and/or corresponding lines of the first connection lines CNT1.

The fault detection circuits FDC may be provided in the first structure 100, however, the present disclosure should not be limited thereto or thereby. According to an implementation, the fault detection circuits FDC may be provided in the second structure 200. When the fault detection circuits FDC are provided in the second structure 200, the fault detection circuits FDC may be connected to corresponding pads of the second test pads TP2 and/or corresponding lines of the second connection lines CNT2.

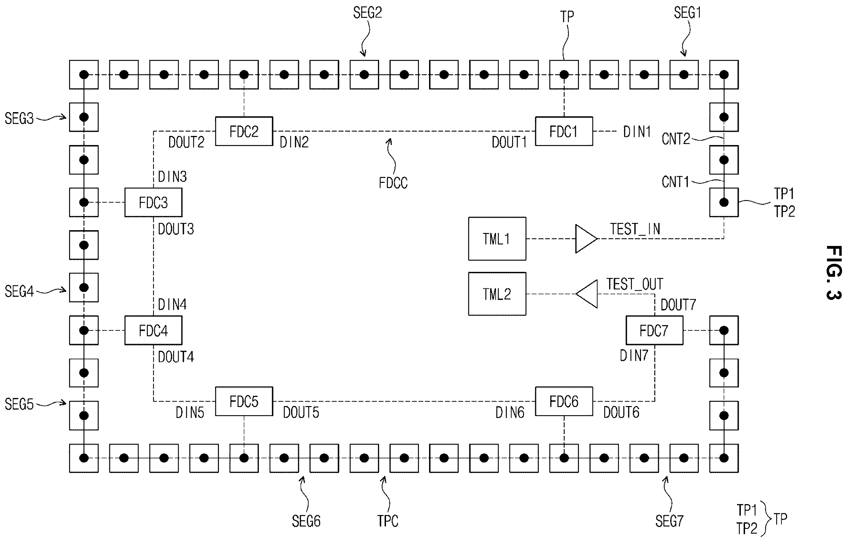

FIG. 3 is a plan view illustrating the test pad chain TPC and the fault detection circuits FDC electrically connected to a corresponding test pad chain TPC according to an implementation of the present disclosure. FIG. 3 illustrates a structure in which the fault detection circuits FDC are connected to each other in series to form a fault detection circuit chain FDCC.

Referring to FIGS. 1 to 3, the test pad chain TPC may include test pads TP, the first connection lines CNT1 electrically connecting the first test pads TP1 formed in the first structure 100, and the second connection lines CNT2 electrically connecting the second test pads TP2 formed in the second structure 200.

Some of the test pads TP, first test pads TP1, may be formed in the first structure 100, and the other of the test pads TP, the second test pads TP2, may be formed in the second structure 200. Each first test pad TP1 may be bonded to a corresponding second test pad TP2. As an example, a first-first test pad TP1 (i.e. a first one of the first test pads TP1) formed in the first structure 100 and a first-second test pad TP2 (i.e. a first one of the second test pads TP1) formed in the second structure 200 may be bonded to each other. Similarly, a second-first test pad TP1 (i.e. a second one of the first test pads TP1) and a third-first test pad TP1 (i.e. a third one of the first test pads TP1), which are formed in the first structure 100, may be respectively bonded to a second-second test pad TP2 (i.e. a second one of the second test pads TP2) and a third-second test pad TP2 (i.e. a third one of the second test pads TP2), which are formed in the second structure 200.

The test pads TP formed in the first structure 100 may be electrically connected to each other by the first connection lines CNT1 formed in the first structure 100. In FIG. 3, for the convenience of explanation, the first connection lines CNT1 formed in the first structure 100 are depicted as a solid line. As an example, the first-first test pad TP1 and the second-first test pad TP1, which are formed in the first structure 100, may be electrically connected to each other by the first connection line CNT1 formed in the first structure 100.

The test pads formed in the second structure 200 may be electrically connected to each other by the second connection lines CNT2 formed in the second structure 200. In FIG. 3, for the convenience of explanation, the second connection line CNT2 formed in the second structure 200 is depicted as a dotted line. As an example, the second-second test pad TP2 and the third-second test pad TP2, which are formed in the second structure 200, may be electrically connected to each other by the second connection line CNT2.

In this manner, the test pads TP of the first structure 100 and the second structure 200 are alternately connected to form the test pad chain TPC.

The fault detection circuit chain FDCC may include a plurality of fault detection circuits FDC1 to FDC7, for example, first, second, third, fourth, fifth, sixth, and seventh fault detection circuits FDC1, FDC2, FDC3, FDC4, FDC5, FDC6, and FDC7. FIG. 3 illustrates the fault detection circuit chain FDCC including seven fault detection circuits as a representative example, however, the present disclosure should not be limited thereto or thereby. According to an implementation, the number of the fault detection circuits may be set to n (n is a natural number greater than or equal to 2).

Each of the fault detection circuits FDC1 to FDC7 may be electrically connected to the test pad chain TPC. As an example, the first fault detection circuit FDC1 may be formed in the first structure 100, and one end of the first fault detection circuit FDC1 may be electrically connected to the test pad chain TPC. Similarly, the second to seventh fault detection circuits FDC2 to FDC7 may be formed in the first structure 100, and each of the second to seventh fault detection circuits FDC2 to FDC7 may be electrically connected to the test pad chain TPC. In the present implementation, each of the first to seventh fault detection circuits FDC1 to FDC7 may be connected to the test pad chain TPC in parallel.

Each of the fault detection circuits FDC1 to FDC7 may store data corresponding to a signal level from the test pad chain TPC. As an example, each of the fault detection circuits FDC1 to FDC7 may include a latch, and the data corresponding to the signal level from the test pad chain TPC may be stored in the latch.

The fault detection circuits FDC1 to FDC7 may be connected to each other in series. As an example, an output terminal of the first fault detection circuit FDC1 may be electrically connected to an input terminal of the second fault detection circuit FDC2. In other words, a data output signal DOUT1 output from the first fault detection circuit FDC1 may be provided to the second fault detection circuit FDC2 as a data input signal DIN2.

Similarly, a data output signal DOUT2 output from the second fault detection circuit FDC2 may be provided to the third fault detection circuit FDC3 as a data input signal DIN3, and a data output signal DOUT3 output from the third fault detection circuit FDC3 may be provided to the fourth fault detection circuit FDC4 as a data input signal DIN4. In addition, a data output signal DOUT4 output from the fourth fault detection circuit FDC4 may be provided to the fifth fault detection circuit FDC5 as a data input signal DINS, a data output signal DOUT5 output from the fifth fault detection circuit FDC5 may be provided to the sixth fault detection circuit FDC6 as a data input signal DIN6, and a data output signal DOUT6 output from the sixth fault detection circuit FDC6 may be provided to the seventh fault detection circuit FDC7 as a data input signal DIN7.

As described above, since the fault detection circuits FDC1 to FDC7 are sequentially connected to each other in series, the fault detection circuit chain FDCC may operate as a shift register.

A test input signal TEST_IN may be provided to one end of the test pad chain TPC. As an example, the test input signal TEST_IN may be provided to the one end of the test pad chain TPC through a first terminal TML1.

The seventh fault detection circuit FDC7, which is the last fault detection circuit, may be connected to the other end of the test pad chain TPC, and a data output signal DOUT7 output from the seventh fault detection circuit FDC7 may be a test output signal TEST_OUT. As an example, the data output signal DOUT7 output from the seventh fault detection circuit FDC7 may be provided to a second terminal TML2 as the test output signal TEST_OUT.

When a test operation is performed, the test input signal TEST_IN may be provided to the one end of the test pad chain TPC.

When no fault exists in the test pad chain TPC, the test input signal TEST_IN may be transmitted to the first to seventh fault detection circuits FDC1 to FDC7. In this case, the first to seventh fault detection circuits FDC1 to FDC7 may each store the same data corresponding to the test input signal TEST_IN.

When a fault exists in a portion of the test pad chain TPC, the test input signal TEST_IN may be transmitted to the fault detection circuit located before a point where the fault occurs among the first to seventh fault detection circuits FDC1 to FDC7, but the test input signal TEST_IN may not be transmitted to the fault detection circuit located after the point where the fault occurs among the first to seventh fault detection circuits FDC1 to FDC7. Based on the point where the fault occurs, the data stored in the fault detection circuit located before the point and the data stored in the fault detection circuit located after the point may be different from each other. Accordingly, the point where the fault occurs in the test pad chain TPC may be detected.

In other words, the test pad chain TPC may be divided into multiple segments depending on connection positions of the fault detection circuits TPC. In the present implementation, the number of the test pads included in the segments may be different from each other. As an example, the test pad chain TPC may be divided into seven segments, i.e., first to seventh segments SEG1, SEG2, SEG3, SEG4, SEG5, SEG6, and SEG7, when the first to seventh fault detection circuits FDC1 to FDC7 are connected to each other. In the test pad chain TPC, the first segment SEG1 may correspond to a portion between the one end of the test pad chain TPC and a position where the first fault detection circuit FDC1 is connected to the test pad chain TPC, the second segment SEG2 may correspond to a portion between the position where the first fault detection circuit FDC1 is connected to the test pad chain TPC and a position where the second fault detection circuit FDC2 is connected to the test pad chain TPC, and the third segment SEG3 may correspond to a portion between the position where the second fault detection circuit FDC2 is connected to the test pad chain TPC and a position where the third fault detection circuit FDC3 is connected to the test pad chain TPC. Two fault detection circuits FDC respectively connected to front and rear ends of each segment may detect the fault of the corresponding segment.

The number of the fault detection circuits FDC and the number of the test pads included in each of the segments may vary depending on the frequency of the bonding pad faults. As an example, when a large number of connection faults in the bonding pads are detected in a specific part of the semiconductor device, the specific part may be provided with more fault detection circuits FDC than other parts. In this case, the number of the test pads included in the segment corresponding to the specific part may be smaller than the number of the test pads included in other segments.

In addition, according to an implementation, the fault detection circuit chain FDCC may be implemented by the shift register in which the fault detection circuits FDC1 to FDC7 are connected to each other in series. In this case, the point where the fault occurs in the test pad chain TPC may be detected based on the number of clock signals applied to the shift register and a transition time of the test output signal TEST_OUT. In other words, without the need to check the data stored in each fault detection circuit, the point where the fault occurs in the test pad chain TPC may be detected based on the number of clock signals applied to the fault detection circuit and the transition time of the test output signal TEST_OUT. Accordingly, the time required for the test operation may be reduced.

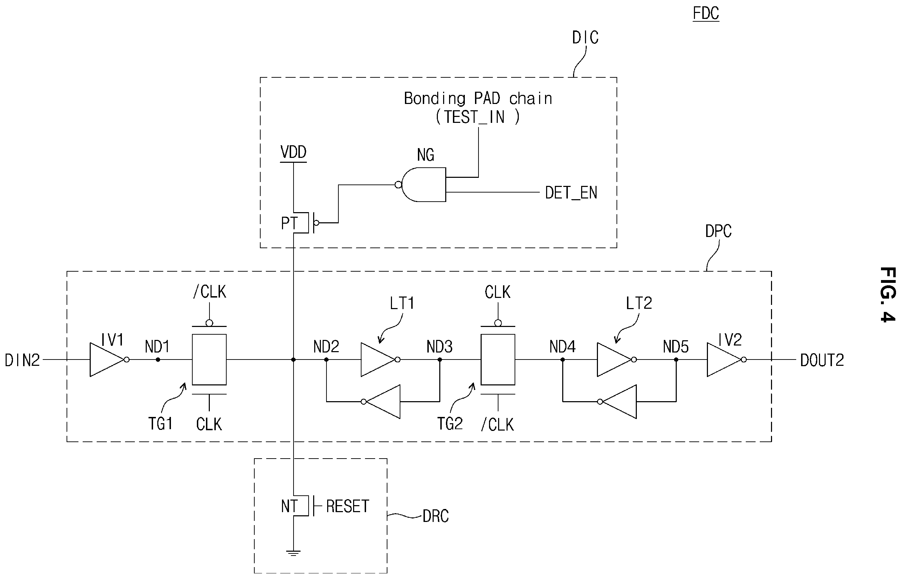

FIG. 4 is a circuit diagram illustrating the fault detection circuit of FIG. 3. The first to seventh fault detection circuits FDC1 to FDC7 of FIG. 3 may have substantially the same circuit configurations. FIG. 4 illustrates one fault detection circuit FDC among the first to seventh fault detection circuits FDC1 to FDC7 as a representative example.

Referring to FIG. 4, the fault detection circuit FDC may include a data input circuit DIC, a data path circuit DPC, and a data reset circuit DRC.

One end of the data input circuit DIC may be connected to the test pad chain TPC. When the test operation is performed, the data input circuit DIC may receive or may not receive the test input signal TEST_IN depending on whether there is a fault in the test pad chain TPC and/or the fault point. The data input circuit DIC may change a voltage level at a second node ND2 based on whether the data input circuit DIC receives the test input signal TEST_IN.

The data input circuit DIC may include, for example, a NAND gate NG and a PMOS transistor PT.

A first input terminal of the NAND gate NG may be connected to the test pad chain TPC. A second input terminal of the NAND gate NG may receive a fault detection activation signal DET _EN.

The PMOS transistor PT may be connected between a power supply voltage VDD and the second node ND2. A gate of the PMOS transistor PT may be connected to an output terminal of the NAND gate NG.

When the test operation is performed, the fault detection activation signal DET_EN may transition from a low state to a high state. In addition, the test input signal TEST_IN at the high state may be transmitted or may not be transmitted depending on whether there is a fault in the test pad chain TPC and/or the fault point.

When no fault occurs before the fault detection circuit FDC, the test input signal TEST_IN at the high state may be transmitted. In this case, the PMOS transistor PT may be turned on, and thus, a voltage level at the second node ND2 may transition from the low state to the high state. That is, the voltage level at the second node ND2 may be changed from a reset state to a set state.

When a fault occurs before the fault detection circuit FDC, the test input signal TEST_IN at the high state may not be transmitted. In this case, the PMOS transistor PT may maintain a turn-off state, and thus, the second node ND2 may also maintain a low state. That is, the voltage level at the second node ND2 may be maintained in the reset state.

The data path circuit DPC may store the voltage level at the second node ND2 as data depending on whether the data input signal TEST_IN is received or not. In addition, responsive to the clock signal, the data path circuit DPC may transmit the stored data to the fault detection circuit, i.e., the third fault detection circuit FDC3 (refer to FIG. 3), which is located after the fault detection circuit FDC. Further, responsive to the clock signal, the data path circuit DPC may receive data from the fault detection circuit, i.e., the first fault detection circuit FDC1 (refer to FIG. 3), which is located before the fault detection circuit FDC, and may store the received data.

The data path circuit DPC may include, for example, first and second inverters IV1 and IV2, first and second transmission gates TG1 and TG2, and first and second latches LT1 and LT2.
The first inverter IV1 may receive the second data input signal DIN2 and may transmit the second data input signal DIN2 to a first node ND1. In the present implementation, the second data input signal DIN2 may be the first data output signal DOUT1 of the first fault detection circuit FDC1.
The second inverter IV2 may be connected to a fifth node ND5 and may output a voltage level corresponding to the fifth node ND5 as the second data output signal DOUT2. In the present implementation, the second data output signal DOUT2 may be the third data input signal DIN3 of the third fault detection circuit FDC3.

The first transmission gate TG1 may be connected between the first node ND1 and the second node ND2 and may be selectively turned on in response to the clock signal CLK and an inverted clock signal /CLK.

The second transmission gate TG2 may be connected between a third node ND3 and a fourth node ND4 and may be selectively turned on in response to the clock signal CLK and the inverted clock signal /CLK.

As an example, when the clock signal CLK is at the high state, the first transmission gate TG1 may be turned on, and the second transmission gate TG2 may be turned off. In this case, the second data input signal DIN2 from the first fault detection circuit FDC1 may be transmitted to the second node ND2, and the second data input signal DIN2 may be stored in the first latch LT1. In addition, similarly, when the clock signal CLK is at the high state, the data stored in the second latch LT2 may be transmitted to a first latch of the third fault detection circuit FDC3 (refer to FIG. 3). That is, when the clock signal CLK is at the high state, the data of the fault detection circuit chain FDCC (refer to FIG. 3) may be shifted one by one.

As an example, when the clock signal CLK is at the low state, the first transmission gate TG1 may be turned off, and the second transmission gate TG2 may be turned on. In this case, an electrical connection between the first fault detection circuit FDC1 and the second fault detection circuit FDC may be broken. In addition, the data stored in the first latch LT1 may be transmitted to and stored in the second latch LT2.

The first latch LT1 may be connected between the second node ND2 and the third node ND3. The first latch LT1 may store the voltage level at the second node ND2, which is controlled by the data input circuit DIC.

The second latch LT2 may be connected between the fourth node ND4 and the fifth node ND5. The second latch LT2 may bs used to transmit the data stored in the second fault detection circuit FDC to the third fault detection circuit FDC3.

The data reset circuit DRC may be connected to the second node ND2 and may reset the voltage level at the second node ND2. As an example, the data reset circuit DRC may include an NMOS transistor NT and may reset the voltage level at the second node ND2 to the low state in response to a reset signal RESET.

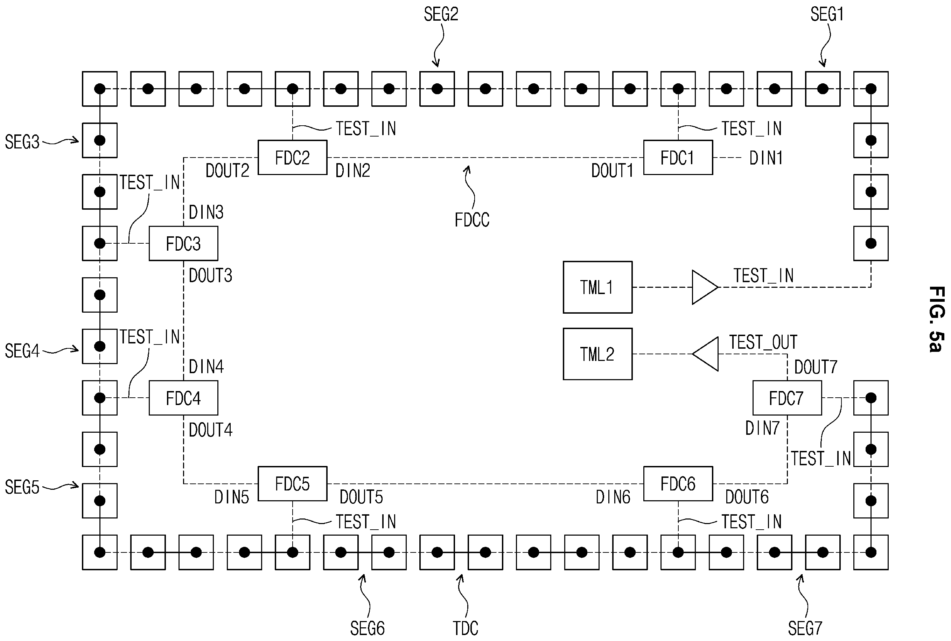

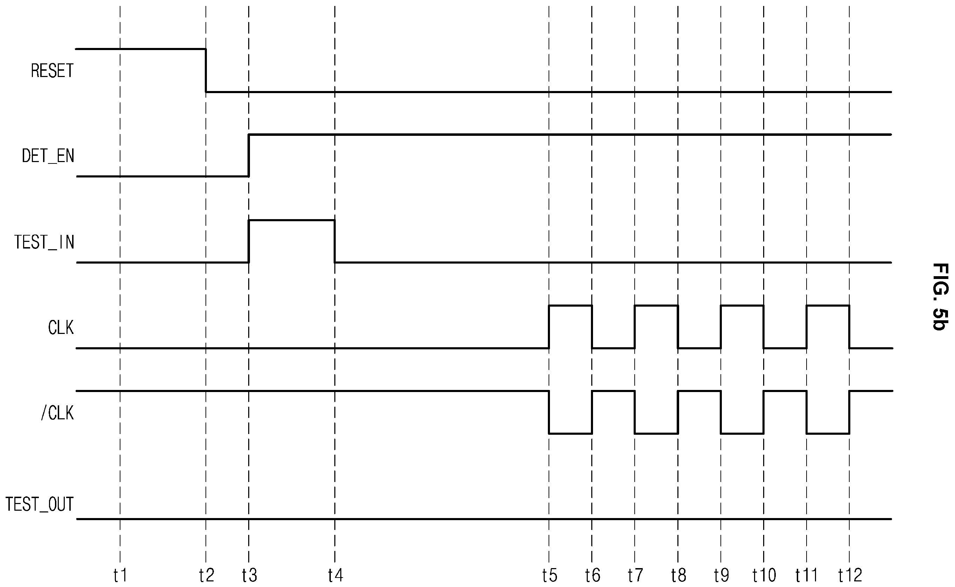

FIGS. 5A and 5B are views illustrating an operation of the fault detection circuit chain FDCC of FIGS. 3 and 4. As an example, FIGS. 5A and 5B illustrate a case where no fault occurs in the test pad chain TPC.

Referring to FIG. 5A, when there is no fault in the test pad chain TPC, the test input signal TEST_IN may be transmitted to all of the first to seventh fault detection circuits FDC1 to FDC7. Accordingly, the test output signal TEST_OUT may not transition.

Referring to FIGS. 4, 5A, and 5B, the reset signal RESET may be maintained in a high state from a first time point t1 to a second time point t2. Accordingly, the voltage level at the second node ND2 may be reset to the low state.

The fault detection activation signal DET_EN may transition from the low state to the high state at a third time point t3. In addition, the test input signal TEST_IN at the high state may be provided from the third time point t3 to a fourth time point t4.

In this case, since no fault exists in the test pad chain TPC, the test input signal TEST_IN at the high state may be provided to all of the first to seventh fault detection circuits FDC1 to FDC7. Therefore, the voltage level at the second node ND2 may transition from the low state to the high state in each of the first to seventh fault detection circuits FDC1 to FDC7.

In this case, since the seventh fault detection circuit FDC7 receives the test input signal TEST_IN at the high state, the test output signal TEST_OUT may be maintained in the low state from the fourth time point t4 to a twelfth time point t12.

Consequently, when the test output signal TEST_OUT is maintained in the low state, it is determined that there is no fault in the test pad chain TPC.

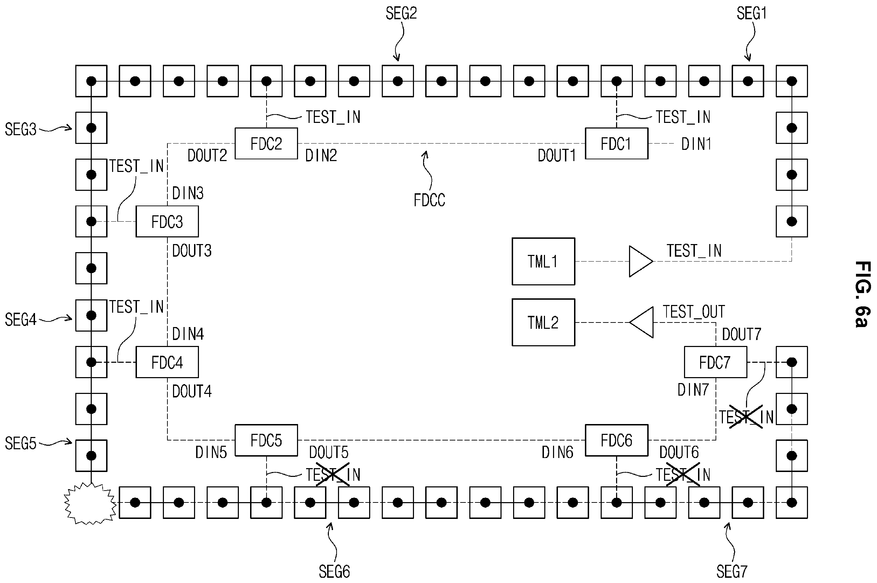

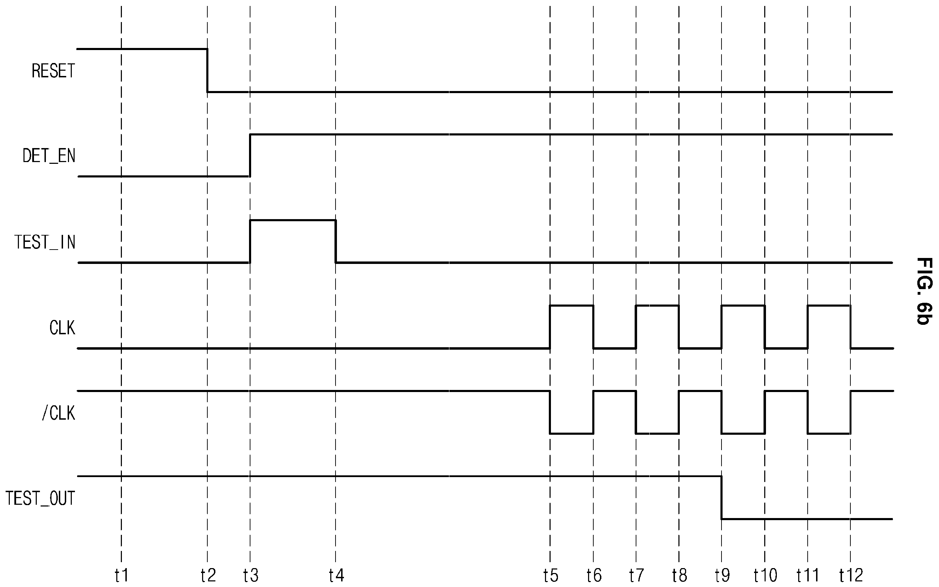

FIGS. 6A and 6B are views illustrating an operation of the fault detection circuit chain FDCC of FIGS. 3 and 4. As an example, FIGS. 6A and 6B illustrate a case where the fault occurs in the test pad located between the fourth fault detection circuit FDC4 and the fifth fault detection circuit FDC5 of the test pad chain TPC, i.e., the fifth segment SEGS.

Referring to FIG. 6A, since the fault occurs in the test pad of the fifth segment SEG5 located between the fourth fault detection circuit FDC4 and the fifth fault detection circuit FDC5, the test input signal TEST_IN may be transmitted to only the first to fourth fault detection circuits FDC1 to FDC4, but the test input signal TEST_IN may not be transmitted to the fifth to seventh fault detection circuits FDC5 to FDC7. Accordingly, data stored in latches of the first to fourth fault detection circuits FDC1 to FDC4 may be different from data stored in latches of the fifth to seventh fault detection circuits FDC5 to FDC7. Therefore, as the data stored in the first to seventh fault detection circuits FDC1 to FDC7 are shifted, the point where the fault occurs may be detected.

Referring to FIGS. 4, 6A, and 6B, the reset signal RESET may be maintained in the high state between the first time point t1 and the second time point t2. Accordingly, the voltage level at the second node ND2 may be reset to the low state.

The fault detection activation signal DET_EN may transition from the low state to the high state at the third time point t3. In addition, the test input signal TEST_IN at the high state may be provided between the third time point t3 and the fourth time point t4.

In this case, since the fault occurs in the test pad located between the fourth fault detection circuit FDC4 and the fifth fault detection circuit FDC5, the test input signal TEST_IN at the high state may be provided to the first to fourth fault detection circuits FDC1 to FDC4, but the test input signal TEST_IN may not be provided to the fifth to seventh fault detection circuits FDC5 to FDC7. Therefore, the voltage level at the second node ND2 of the first to fourth fault detection circuits FDC1 to FDC4 may transition from the low state to the high state, and the voltage level at the second node ND2 of the fifth to seventh fault detection circuits FDC5 to FDC7 may be maintained in the low state.

The test output signal TEST_OUT may be maintained in the high state between the fourth time point t4 and a fifth time point t5. That is, since the test input signal TEST_IN is not transmitted to the seventh fault detection circuit FDC7, the test output signal TEST_OUT may be maintained in the high state from the fourth time point t4 to the fifth time point t5.

A first clock signal may be provided between the fifth time point t5 and a sixth time point t6. Therefore, data stored in the fault detection circuits FDC1 to FDC7 of the fault detection circuit chain FDCC may be shifted one by one. In other words, data of the test output signal TEST _OUT at the sixth time point t6 may be the data stored in the sixth fault detection circuit FDC6. In this case, since the test output signal TEST_OUT may be maintained in the high state, it may be determined that the test input signal TEST_IN is not transmitted to the sixth fault detection circuit FDC6.

A second clock signal may be provided between a seventh time point t7 and an eighth time point t8. Accordingly, the data stored in the fault detection circuits FDC1 to FDC7 of the fault detection circuit chain FDCC may be shifted one by one. In other words, data of the test output signal TEST_OUT at the eighth time point t8 may be the data stored in the fifth fault detection circuit FDC5. In this case, since the test output signal TEST_OUT is maintained at the high state, it may be determined that the test input signal TEST_IN is not transmitted to the fifth fault detection circuit FDC5.

A third clock signal may be provided between a ninth time point t9 and a tenth time point t10. Accordingly, the data stored in the fault detection circuits FDC1 to FDC7 of the fault detection circuit chain FDCC may be shifted one by one. In other words, data of the test output signal TEST _OUT at the tenth time point t10 may be the data stored in the fourth fault detection circuit FDC4. In this case, since the test output signal TEST_OUT may transition from the high state to the low state, it may be determined that the test input signal TEST_IN is transmitted to the fourth fault detection circuit FDC4. Accordingly, it may be determined that the fault occurs in the test pad located between the fourth fault detection circuit FDC4 and the fifth fault detection circuit FDC5 in the test pad chain TPC.

Consequently, based on the number of times the clock signal is applied and whether there is a transition in the test output signal TEST_OUT, the location of the fault within the test pad chain TPC may be accurately detected.

As described above, the semiconductor device according to the present disclosure may easily detect whether the fault occurs in the test pad chain TPC using the fault detection circuits connected to the test pad chain TPC. In addition, the semiconductor device according to the present disclosure may accurately detect the point of the fault in the test pad chain TPC.

According to the present disclosure, by detecting the presence and location of faults in the test pad chain TPC, the presence and locations of faults in the bonding pads between the first structure 100 and the second structure 200 may also be easily predicted. As the presence and locations of faults in the bonding pads are easily predicted, the test time of the bonding pads may be reduced, and thus, the reliability of the semiconductor device may be improved.

According to an implementation, the test pad chain may be implemented in a different structure from the above-described structure in the first and second structures. In the following implementations, for the sake of convenience, descriptions will focus on differences from the abovementioned structure.

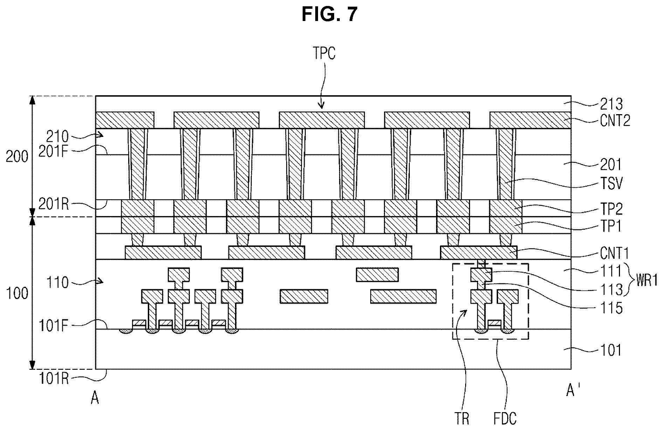

FIG. 7 is a cross-sectional view illustrating a semiconductor device taken along a line A-A' of FIG. 1 according to an implementation of the present disclosure.

Referring to FIGS. 1 and 7, the semiconductor device may include a first structure 100 and a second structure 200.

The first structure 100 may include a first substrate 101, a first circuit layer 110, first bonding pads BP1, and first test pads TP1.

The first substrate 101 may include a front surface 101F and a rear surface 101R.

The first circuit layer 110 may be provided in the first substrate 101 and/or on the first substrate 101. As an example, the first circuit layer 110 may be provided on the front surface 101F of the first substrate 101.

The first circuit layer 110 may include a plurality of fault detection circuits FDC electrically connected to a test pad chain TPC. The first circuit layer 110 may include memory cells in addition to the fault detection circuit FDC. The first circuit layer 110 may include a dynamic random access memory (DRAM), however, the type of memory cells should not be limited thereto or thereby. According to an implementation, the first circuit layer 110 may include memory cells such as a static random access memory (SRAM), a flash memory, a phase-change random access memory (PRAM), a magneto-resistive random access memory (MRAM), a ferroelectric random access memory (FeRAM), or a resistive random access memory (RRAM).

In the present implementation, the first circuit layer 110 may include the fault detection circuits FDC, however, the present disclosure should not be limited thereto or thereby. According to an implementation, the fault detection circuits FDC may be provided in the second circuit layer 210.

Upper surfaces of each of the first bonding pads BP1 and the first test pads TP1 may form an uppermost surface of the first structure 100. As an example, the upper surfaces of the first bonding pads BP1 and the upper surfaces of the first test pads TP1 may be disposed in an uppermost inter-layer insulating layer among inter-layer insulating layers 111 of the first structure 100.

The second structure 200 may include a second substrate 201, a second circuit layer 210, second bonding pads BP2, and second test pads TP2.

The second substrate 201 may include a front surface 201F and a rear surface 201R. The front surface 101F of the first substrate 101 and the rear surface 201R of the second substrate 201 may be arranged to face each other as shown in FIG. 7.

The second circuit layer 210 and the second test pads TP2 may be provided on the front surface 201F of the second substrate 201.

The second circuit layer 210 may include a variety of circuits, for example, core circuits and peripheral circuits of memory devices. In FIG. 7, for the convenience of explanation, the second circuit layer 210 is illustrated as a single layer, however, the second circuit layer 210 may include transistors and a wiring layer.

The second bonding pads BP2 and the second test pads TP2 may be provided on the rear surface 201R of the second substrate 201.

Since the rear surface 201R of the second substrate 201 is disposed to face the front surface 101F of the first substrate 101, the second bonding pads BP2 may be bonded to the first bonding pads BP1, and the second test pads TP2 may be bonded to the first test pads

TP1.

Each of the second bonding pads BP2 and the second test pads TP2 may be respectively connected to through vias TSV penetrating through the front surface 201F and the rear surface 201R.

The through vias TSV connected to the second test pads TP2 may be connected to each other by second connection lines CNT2. The second connection lines CNT2 may connect the through vias TSV adjacent to each other among the through vias TSV.

The first test pads TP1, first connection lines CNT1, the second test pads TP2, the through vias TSV, and the second connection lines CNT2 may form the test pad chain TPC.

Each of the first connection lines CNT1 may connect a pair of the first test pads TP1 placed adjacent to each other among the first test pads TP1 using the through vias TSV. The first connection lines CNT1 may not consecutively connect all of the first test pads TP1. In addition, each of the second connection lines CNT2 may connect a pair of the second test pads TP2 placed adjacent to each other among the second test pads TP2 using the through vias TSV. The second connection lines CNT2 may not consecutively connect the through vias TSV connected to the second test pads TP2.

As described above, the first connection lines CNT1 and the second connection lines CNT2 may alternately and sequentially connect adjacent first test pads TP1 and adjacent second test pads TP2. For example, returning to FIG. 2, a first-first test pad corresponds to a first-second test pad. A second-first test pad corresponds to a second-second test pad. A third-first test pad corresponds to a third-second test pad. A first connection line of the first connection lines can connect the first-first test pad of the first test pads to the second-first test pad of the first test pads. A second connection line of the second connection lines can connect the second-second test pad of the second test pads to the third-second test pad of the second test pads.

According to the implementation, the first circuit layer 110 may include core circuits and peripheral circuits of memory devices, and the second circuit layer 210 may include memory cells, however, the present disclosure should not be limited thereto or thereby. According to an implementation, the first circuit layer 110 may include memory cells, and the second circuit layer 210 may include core circuits and peripheral circuits.

In addition, the fault detection circuits FDC may be provided in the first structure 100 according to the above-described implementation, however, the present disclosure should not be limited thereto or thereby, and the fault detection circuits FDC may be provided in the second structure 200. In other words, the fault detection circuits FDC may be provided in the first structure 100, the second structure 200, or both the first and second structures 100 and 200. In this case, the fault detection circuits FDC may be connected to the first test pads TP1 and/or the first connection lines CNT1 of the first structure 100 or may be connected to the second test pads TP2 and/or the second connection lines CNT2 of the second structure 200.

In addition, the first circuit layer 110 may be disposed on the front surface 101F and/or the rear surface 101R of the first substrate 101, and the second circuit layer 210 may be disposed on the front surface 201F and/or the rear surface 201R of the second substrate 201. As an example, when outer surfaces of the first and second structures 100 and 200, which respectively correspond to the front surfaces and the rear surfaces of the and second substrates 101 and 201, are referred to as a front surface and a rear surface, the semiconductor device may have a structure in which the front surface of the first structure 100 faces the front surface of the second structure 200, a structure in which the rear surface of the first structure 100 faces the front surface of the second structure 200, a structure in which the front surface of the first structure 100 faces the rear surface of the second structure 200, or a structure in which the rear surface of the first structure 100 faces the rear surface of the second structure 200.

Electronic components within the first structure 100 and/or the second structure 200, such as various integrated circuits and wirings, may be modified in various ways depending on the structure and process sequence of the semiconductor device to be manufactured. As an example, when the first structure 100 is bonded to the second structure 200, the first and second structures 100 and 200 may be bonded to each other after at least one of the first structure 100 and the second structure 200 is inverted.

According to an implementation, the semiconductor device may be a memory device having a CoP (Cell over Peripheral) structure.

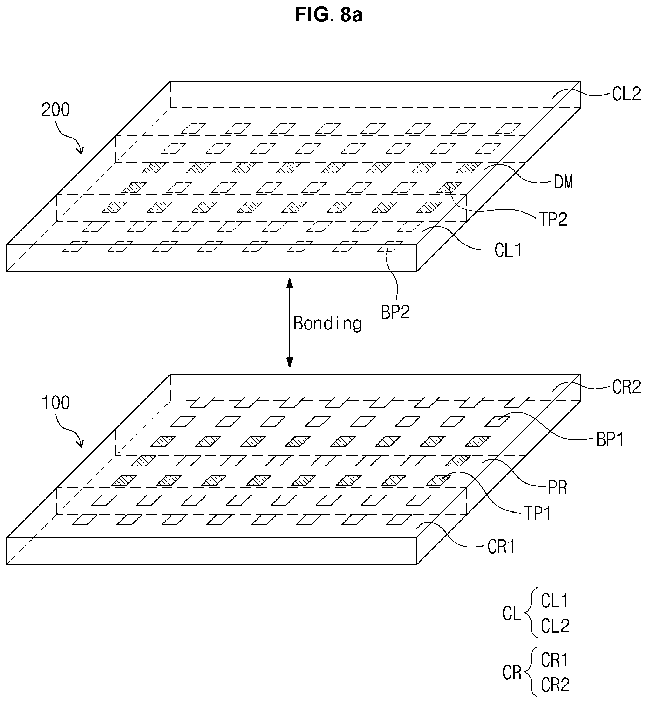

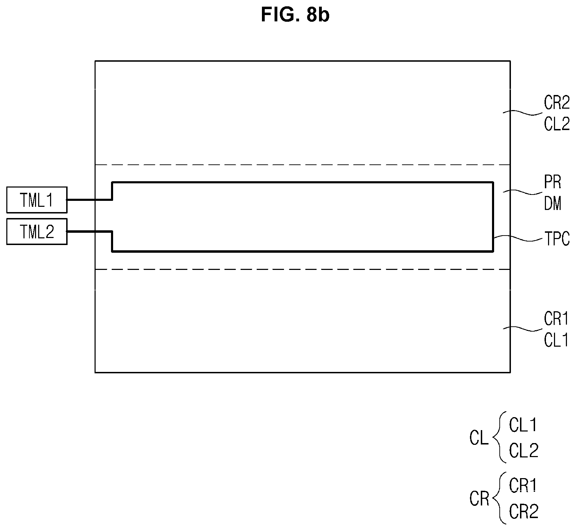

FIG. 8A is a conceptual view illustrating a portion of a semiconductor device according to an implementation of the present disclosure, and FIG. 8B is a plan view illustrating the semiconductor device of FIG. 8A. FIG. 8A illustrates positions of first test pads and second test pads of a test pad chain, and FIG. 8B schematically illustrates a connection structure of the test pad chain.

Referring to FIGS. 8A and 8B, the semiconductor device may include a first structure 100 and a second structure 200. The first structure 100 and the second structure 200 may have a stacked structure. As an example, the first structure 100 and the second structure 200 may have a CoP (Cell over Peripheral) structure.

The CoP structure may be obtained by manufacturing a first wafer including a plurality of memory cells and a second wafer including a core circuit and a peripheral circuit and stacking the first wafer on the second wafer to connect the first wafer and the second wafer. In the following descriptions, the first wafer (or a first die) on which the memory cells are arranged may correspond to the first structure 100. In addition, the second wafer (or a second die) on which the core circuits and the peripheral circuits, which control an operation of the memory cells, are arranged may correspond to the second structure 200.

The first structure 100 and the second structure 200 of the CoP structure may be electrically connected to each other through a bonding method. As an example, the first structure 100 and the second structure 200 may be electrically connected to each other by bonding first bonding pads BP1 of the first structure 100 to second bonding pads BP2 of the second structure 200.

The second structure 200 may include the memory cells. The first structure 100 may include circuits that control the operation of the memory cells of the second structure 200. Hereinafter, for the convenience of explanation, the second structure 200 will be described first, followed by the description of the first structure 100.

The second structure 200 may include the memory cells. The second structure 200 may include a cell area CL in which the memory cells are arranged and a remaining area, e.g., a dummy area DM, in which the memory cells are not arranged.

The second structure 200 may include a first cell area CL1 and a second cell area CL2 spaced apart from the first cell area CL1. In addition, the second structure 200 may include the dummy area DM defined between the first cell area CL1 and the second cell area CL2. However, the present disclosure should not be limited thereto or thereby, and the number and position of the cell area CL and the dummy area DM should not be particularly limited.

The cell area CL may include a memory cell array. The memory cell array may include the memory cells respectively formed at points at which word lines intersect bit lines. According to an implementation, the memory cell array may include a plurality of cell array mats that is divided into regions, each managed by a sub-word line driver.

The first structure 100 may include the core circuits and the peripheral circuits to control the operation of the memory cells included in the second structure 200. The core circuits may include, for example, the sub-word line driver, a bit line sense amplifier, a row decoder (or an X-decoder), and a column decoder (or a Y-decoder). The peripheral circuits may include various circuits for decoding commands and controlling input/output of addresses and data. As an example, the peripheral circuits may include control logics, address buffers, delayed-locked loops (DLLs), data input/output buffers, power circuits, etc. In the present implementation, the power circuit may be a circuit that generates various DC voltages required for the operation of the semiconductor device.

Meanwhile, the first structure 100 may include a core region CR in which the core circuits are arranged and a peripheral region PR in which the peripheral circuits are arranged. In this case, according to an implementation, the core region CR may correspond to the cell area CL, and the peripheral region PR may correspond to the dummy area DM. As an example, when the second structure 200 is bonded to the first structure 100, the cell area CL may overlap the core region CR, and the dummy area DM may overlap the peripheral region PR, however, the present disclosure should not be limited thereto or thereby.

The first structure 100 may include a first core region CR1 in which first core circuits corresponding to the memory cells of the first cell area CL1 are arranged and a second core region CR2 in which second core circuits corresponding to the memory cells of the second cell area CL2 are arranged. In this case, the first core region CR1 and the second core region CR2 may be spaced apart from each other. In addition, the first structure 100 may include the peripheral region PR defined between the first and second core regions CR1 and CR2. In this case, the peripheral region PR may include the peripheral circuits.

Meanwhile, the number and position of the core region CR and the peripheral region PR should not be limited thereto or thereby and may be changed depending on implementations. However, the number and position of the core region CR are required to correspond to the number and position of the cell area CL, and the number and position of the peripheral region PR are required to correspond to the number and position of the dummy area DM.

According to an implementation, signals generated by the core circuits of the first structure 100 may be transmitted to the first bonding pads BP1 through a first circuit layer of the first structure 100. The signals transmitted to the first bonding pads BP1 may be transmitted to the second structure 200 through the second bonding pads BP2. The signals transmitted to the second structure 200 may be transmitted to the word lines or the bit lines connected to the memory cells through wirings.

The test pad chain TPC may be provided in a portion of each of the first structure 100 and the second structure 200. As an example, the test pad chain TPC may be provided in the dummy area DM of the second structure 200 and the peripheral region PR of the first structure 100. In detail, the first test pads TP1 and first connection lines, which form the test pad chain TPC, may be arranged in the peripheral region PR of the first structure 100, and the second test pads TP2 and second connection lines, which form the test pad chain TPC, may be arranged in the dummy area DM of the second structure 200. Multiple fault detection circuits may be provided in the peripheral region PR of the first structure 100 and may be connected to the first test pads TP1 and/or the first connection lines. The fault detection circuits may be provided in areas other than the peripheral region PR in a case where a space for installing the multiple fault detection circuits FDC is available.

A first terminal TML1 connected to one end of the test pad chain TPC and a second terminal TML2 connected to the other end of the test pad chain TPC may receive external signals or may output signals to the outside through wirings. The first terminal TML1 and the second terminal TML2 may be provided in the first structure 100 and/or the second structure 200, for example, may be provided in the second structure 200. According to an implementation, an upper surface of each of the first terminal TML1 and the second terminal TML2 may form an uppermost surface or a lowermost surface of the second structure.

According to an implementation, the position of the test pad chain TPC may be changed.

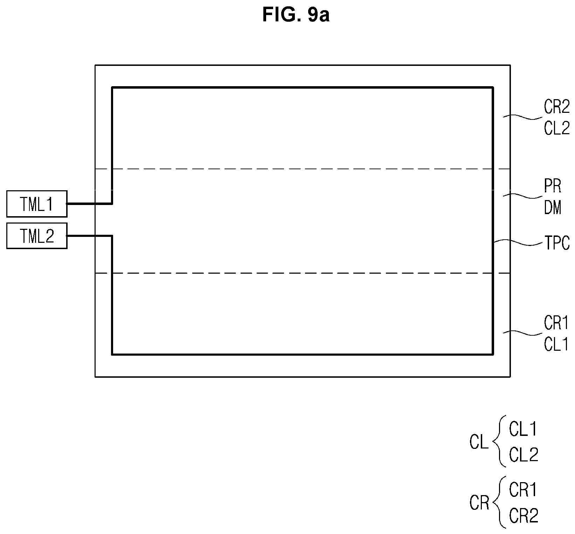

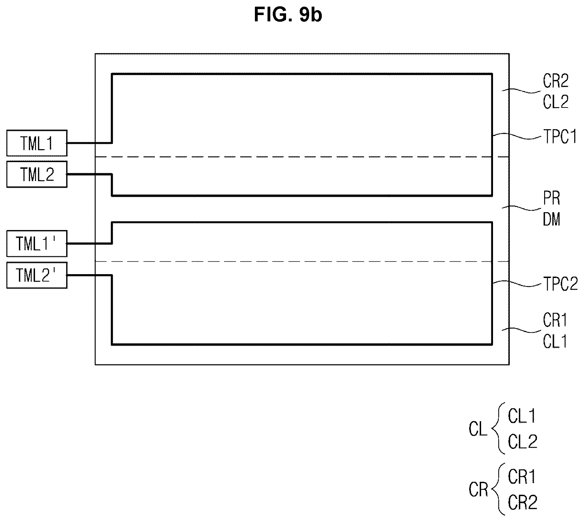

FIGS. 9A and 9B are plan views schematically illustrating connection structures of test pad chains TPC according to implementations of the present disclosure.

Referring to FIG. 9A, the test pad chain TPC may be provided over a core region CR and a peripheral region PR of a first structure 100 and may also be provided over a cell area CL and a dummy area DM of a second structure 200. In detail, first test pads and first connection lines, which form the test pad chain TPC, may be arranged in the peripheral region PR and the core region CR of the first structure 100, and second test pads and second connection lines, which form the test pad chain TPC, may be arranged in the cell area CL and the dummy area DM of the second structure 200. Multiple fault detection circuits may be arranged in the peripheral region PR of the first structure 100 and may be connected to the first test pads and/or the first connection lines. The fault detection circuits may be provided in areas other than the peripheral region PR in a case where a space for installing the multiple fault detection circuits is available.

Referring to FIG. 9B, the test pad chain TPC may be provided in plural. As an example, the test pad chain TPC may include a first test pad chain TPC1 and a second test pad chain TPC2. The first test pad chain TPC1 and the second test pad chain TPC2 may be disposed at different positions in a semiconductor device and may detect faults in bonding pads located at different positions.

The test pad chains TPC1 and TPC2 may be provided at portions of the first and second structures 100 and 200. As an example, first test pads of the first test pad chain TPC1 may be arranged in a first core region CR1 and a peripheral region PR, and the first test pads of the second test pad chain TPC2 may be arranged in a second core region CR2 and the peripheral region PR. Second test pads of the first test pad chain TPC1 may be arranged in a first cell area CL1 and a dummy area DM, and the second test pads of the second test pad chain TPC2 may be arranged in a second cell area CL2 and the dummy area DM.

The arrangement area and number of the test pad chains TPC may be configured differently depending on the frequency of the bonding pad faults. As an example, when the frequency of the bonding pad faults in a specific area (e.g., a particular part of the cell area CL and a part of the core region CR corresponding the particular part of the cell area CL) is high, the test pad chain TPC may be arranged in the specific area.

The above-described implementations may be applied to semiconductor memory devices each including the memory cell array.

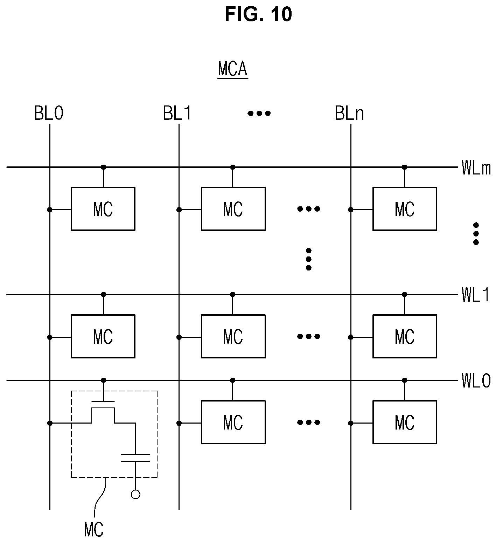

FIG. 10 is a view illustrating a memory cell array MCA of a semiconductor memory device according to an implementation of the present disclosure. Referring to FIG. 10, the memory cell array MCA may include a plurality of word lines WL0 to WLm, a plurality of bit lines BL0 to BLn, and a plurality of memory cells MC respectively disposed at points at which the word lines WL0 to WLm intersect the bit lines BL0 to BLn.

According to an implementation, each memory cell MC may be a DRAM cell. As an example, each of the memory cells MC may include a cell transistor connected to the word lines and the bit lines and a cell capacitor connected to the cell transistor. In this case, the cell transistor may be a vertical channel transistor.

Since the vertical channel transistor has a different structure from a horizontal channel transistor, the vertical channel transistor and the horizontal channel transistor may be implemented by different wafers. According to the present disclosure, each memory cell MC may be implemented by the vertical channel transistor. In addition, core circuits or peripheral circuits may be implemented by the horizontal channel transistor.

Accordingly, the memory cells included in the memory cell array may be implemented in a first structure including the vertical channel transistors, and the core circuits and the peripheral circuits may be implemented in a second structure including the horizontal channel transistors. Therefore, the semiconductor memory device with the CoP structure may be implemented by bonding the first structure to the second structure.

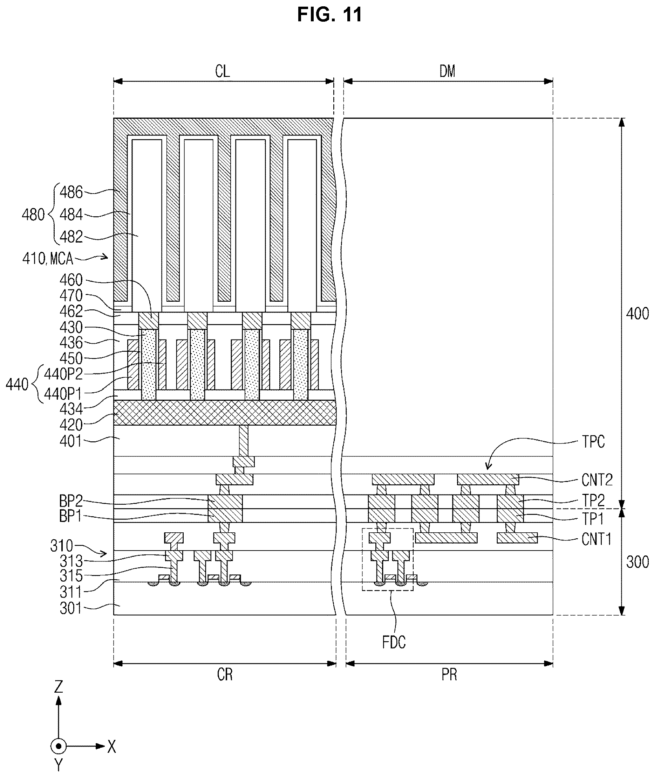

FIG. 11 is a cross-sectional view illustrating a semiconductor memory device, e.g., a DRAM device, according to an implementation of the present disclosure.

Referring to FIGS. 10 and 11, the semiconductor memory device may include a first structure 300 and a second structure 400.

The first structure 300 may include a first substrate 301, a first circuit layer 310, first bonding pads BP1, and first test pads TP1. A core circuit, a peripheral circuit, and a fault detection circuit FDC may be provided in the first circuit layer 310. The first structure 300 may include a core region CR and a peripheral region PR.

The second structure 400 may include a second substrate 401, a second circuit layer 410, second bonding pads BP2, and second test pads TP2. The second circuit layer 410 may include a memory cell array MCA. The second structure 400 may include a cell area CL corresponding to the core region CR and a dummy area DM corresponding to the peripheral region PR.

The memory cell array MCA may be provided in the cell area CL. The structure of the memory cell array MCA will be described later.

The first bonding pads BP1 may be arranged in the core region CR, and the first test pads TP1 may be arranged in the peripheral region PR. The first test pads TP1 may be connected to each other by first connection lines CNT1, and the second test pads TP2 may be connected to each other by second connection lines CNT2. The second bonding pads BP2 may be arranged in the cell area CL and may be bonded to the first bonding pads BP1 of the core region CR. The second test pads TP2 may be arranged in the dummy area DM and may be bonded to the first test pads TP1 of the peripheral region PR.

The memory cell array MCA may be connected to the core circuit and/or the peripheral circuit by bonding the first bonding pads BP1 to the second bonding pads BP2. As an example, core circuits, for example, a sub-word line driver and a bit line sense amplifier, corresponding to memory cells may be connected to the memory cells through the first bonding pads BP1 and the second bonding pads BP2.

The first test pads TP1 and the second test pads TP2 bonded to the first test pads TP1 may form a test pad chain TPC. The test pad chain TPC may be used to detect faults in bonding between the first bonding pads BP1 and the second bonding pads BP2. The test pad chain TPC may detect whether the sub-word line driver (SWD) and the bit line sense amplifier (BLSA) are appropriately connected to the memory cells through the first bonding pads BP1 and the second bonding pads BP2.

The fault detection circuit FDC may be provided in plural, and the fault detection circuits FDC may be arranged in the peripheral region PR of the first structure 300. Each of the fault detection circuits FDC may be connected to a corresponding first connection line among the first connection lines CNT1.

The memory cell array MCA may include the second substrate 401, a plurality of first conductive lines 420, a channel layer 430, a gate electrode 440, a gate insulating layer 450, and a capacitor structure 480. In this case, the memory cell array MCA may include a vertical channel transistor (VCT). The vertical channel transistor may refer to a structure in which a channel length of the channel layer 430 extends from the second substrate 401 along a vertical direction.

Multiple first conductive lines 420 may extend in a first direction (an X-direction) on the second substrate 401 and may be spaced apart from each other in a second direction (a Y-direction). Multiple first insulating patterns (not shown) may be arranged on the second substrate 401 to fill spaces between the first conductive lines 420. The first insulating patterns may extend in the first direction (X-direction), and upper surfaces of the first insulating patterns may be positioned at the same level as upper surfaces of the first conductive lines 420. The first conductive lines 420 may function as the bit lines of the memory cell array MCA.

According to some implementations, the first conductive lines 420 may include doped polysilicon, metal, conductive metal nitride, conductive metal silicide, conductive metal oxide, or a combination thereof. As an example, the first conductive lines 420 may include the doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOX, or a combination thereof, however, the present disclosure should not be limited thereto or thereby. Each of the first conductive lines 420 may have a single-layer or multi-layer structure of the above-described materials. According to implementations, the first conductive lines 420 may include a two-dimensional semiconductor material. As an example, the two-dimensional semiconductor material may include graphene, carbon nanotube, or a combination thereof.

The channel layers 430 may be arranged in a matrix form to be spaced apart from each other in the first direction (X-direction) and the second direction (Y-direction) on the first conductive lines 420. A lower portion of each channel layer 430 may function as a first source/drain area (not shown), an upper portion of each channel layer 430 may function as a second source/drain area, and a portion of each channel layer 430 between the first and second source/drain areas may function as a channel area (not shown).

The channel layer 430 may be formed of a semiconductor material, such as Si, Ge, or SiGe. According to an implementation, the channel layer 430 may include an oxide semiconductor. As an example, the oxide semiconductor may include InxGayZnzO, InxGaySizO, InxSnyZnzO, InxZnyO, ZnxO, ZnxSnyO, ZnxOyN, ZrxZnySnzO, SnxO, HfxInyZnzO, GaxZnySnzO, AlxZnySnzO, YbxGayZnzO, InxGayO, or a combination thereof. The channel layer 430 may have a single-layer or multi-layer of the oxide semiconductor. The channel layer 430 may have a polycrystalline or amorphous structure, but is not limited thereto or thereby. According to some implementations, the channel layer 430 may include a two-dimensional semiconductor material. As an example, the two-dimensional semiconductor material may include graphene, carbon nanotube, or a combination thereof.

The gate electrode 440 may extend in the second direction (Y-direction) on both sidewalls of the channel layer 430. The gate electrode 440 may include a first sub-gate electrode 440P1 facing a first sidewall of the channel layer 430 and a second sub-gate electrode 440P2 facing a second sidewall opposite to the first sidewall of the channel layer 430. As one channel layer 430 is disposed between the first sub-gate electrode 440P1 and the second sub-gate electrode 440P2, a cell transistor of the memory cell array MCA may have a dual-gate transistor structure, however, the present disclosure should not be limited thereto or thereby. According to an implementation, the second sub-gate electrode 440P2 may be omitted, and only the first sub-gate electrode 440P1 facing the first sidewall of the channel layer 430 may be formed to implement a single-gate transistor structure.

The gate electrode 440 may include doped polysilicon, metal, conductive metal nitride, conductive metal silicide, conductive metal oxide, or a combination thereof. As an example, the gate electrode 440 may include the doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOX, or a combination thereof, but the present disclosure should not be limited thereto or thereby.

The gate insulating layer 450 may surround the sidewall of the channel layer 430 and may be disposed between the channel layer 430 and the gate electrode 440. As an example, as shown in FIG. 11, the sidewall of the channel layer 430 may be entirely surrounded by the gate insulating layer 450, and a portion of the gate electrode 440 may be in contact with the gate insulating layer 450. According to an implementation, the gate insulating layer 450 may extend in an extension direction of the gate electrode 440, i.e., the second direction (Y-direction), and only two sidewalls facing the gate electrode 440 among the sidewalls of the channel layer 430 may be in contact with the gate insulating layer 450.

According to implementations, the gate insulating layer 450 may include a silicon oxide layer, a silicon oxynitride layer, a high-k dielectric layer with a higher dielectric constant than the silicon oxide layer, or a combination thereof. The high-k dielectric layer may include metal oxide or metal oxynitride. As an example, the high-k dielectric layer that is able to be used as the gate insulating layer 450 may include HfO2, HfSiO, HfSiON, HfTaO, HfTiO, HfZrO, ZrO2, Al2O3, or a combination thereof, however, it should not be limited thereto or thereby.

Multiple second insulating patterns (not shown) may extend in the second direction (Y-direction) on the first insulating patterns, and the channel layer 430 may be disposed between two second insulating patterns adjacent to each other among the second insulating patterns. In addition, a first buried layer 434 and a second buried layer 436 may be disposed in a space between two channel layers 430 adjacent to each other, which are arranged between two second insulating patterns adjacent to each other. The first buried layer 434 may be disposed on a bottom in the space between the two channel layers 430 adjacent to each other, and the second buried layer 436 may be disposed on the first buried layer 434 to fill a remaining space between the two channel layers 430 adjacent to each other. An upper surface of the second buried layer 436 may be positioned at the same level as an upper surface of the channel layer 430, and the second buried layer 436 may cover an upper surface of the gate electrode 440. Different from the above implementation, the second insulating patterns may be formed as a continuous material layer with the first insulating patterns, or the second buried layer 436 may be formed as a continuous material layer with the first buried layer 434.

Capacitor contacts 460 may be disposed on the channel layer 430. The capacitor contacts 460 may be disposed to vertically overlap the channel layer 430 when viewed in a third direction (or a Z-direction) and may be arranged in a matrix form to be spaced apart from each other in the first direction (X-direction) and the second direction (Y-direction). The capacitor contact 460 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOX, or a combination thereof, but it should not be limited thereto or thereby. An upper insulating layer 462 may surround a sidewall of the capacitor contact 460 on the second insulating patterns and the second buried layer 436.

An etch stop layer 470 may be disposed on the upper insulating layer 462, and the capacitor structure 480 may be disposed on the etch stop layer 470. The capacitor structure 480 may include a lower electrode 482, a capacitor dielectric layer 484, and an upper electrode 486.

The lower electrode 482 may be electrically connected to an upper surface of the capacitor contact 460 after penetrating through the etch stop layer 470. The lower electrode 482 may have a pillar shape extending in the third direction (Z-direction), however, it should not be limited thereto or thereby. According to implementations, the lower electrode 482 may be provided in plural, and the lower electrodes 482 may be disposed to vertically overlap the capacitor contacts 460 respectively when viewed in the third direction (Z-direction) and may be spaced apart from each other in the first direction (X-direction) and the second direction (Y-direction) in a matrix form. According to an implementation, a landing pad (not shown) may be further disposed between the capacitor contact 460 and the lower electrode 482, and the lower electrodes 482 may be arranged in a hexagonal shape when viewed in a plane.

According to the present disclosure, various types of memory cells with different structures may be employed in the semiconductor memory device. As an example, the above-described memory cell may include the capacitor as its data storage element, however, the data storage element should not be limited to the capacitor. According to some implementations, the data storage element may be a variable resistance pattern that is switched between two resistance states in response to an electrical pulse applied thereto. As an example, the data storage element may include a phase-change material whose crystalline state changes depending on the amount of current, perovskite compounds, transition metal oxide, or a magnetic tunnel junction (MTJ) pattern.

In addition, according to implementations, some of the components described above may be omitted depending on changes in the structure of memory cells. As an example, the second substrate 401 may be omitted, and the second bonding pads BP2 and the second test pads TP2 may be arranged on the second circuit layer 410 without the second substrate 401. According to some implementations, the second substrate 401 may be used to form the first circuit layer 310 on the second substrate 401 in a manufacturing process of the second structure 400. The second substrate 401 may be removed by a variety of processes, for example, a chemical mechanical polishing process, after the first circuit layer 310 is formed. In this case, the final semiconductor memory device may not include the second substrate 401.

The implementation of the present disclosure may be applied to semiconductor devices with different structures, such as semiconductor memory devices with different structures, as long as it does not depart from the concept of the present disclosure.

Although the implementations of the present disclosure have been described, it is understood that the present disclosure should not be limited to these implementations but various changes and modifications can be made by one ordinary skilled in the art within the scope of the appended claims.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a first structure (100; 300) comprising first test pads (TP1);
a second structure (200; 400) on the first structure (100; 300) and comprising second test pads (TP2), the second test pads (TP2) corresponding to the first test pads (TP1), respectively, and the first test pads (TP1) and the second test pads (TP2) forming a test pad chain (TPC);
a first terminal (TML1) connected to a first end of the test pad chain (TPC);
a plurality of fault detection circuits (FDC, FDC1-FDC7) connected to the test pad chain (TPC), the plurality of fault detection circuits (FDC, FDC1-FDC7) configured to detect a connection status of the test pad chain (TPC); and
a second terminal (TML2) connected to a second end of the test pad chain (TPC).

2. The semiconductor device of claim 1, wherein the plurality of fault detection circuits (FDC, FDC1-FDC7) are connected to the test pad chain (TPC) in parallel.

3. The semiconductor device of claim 2, wherein the plurality of fault detection circuits (FDC, FDC1-FDC7) are connected to one another in series.

4. The semiconductor device of claim 3, wherein the plurality of fault detection circuits (FDC, FDC1-FDC7) form a fault detection circuit chain (FDCC), and the fault detection circuit chain (FDCC) comprises a shift register.

5. The semiconductor device of claim 4, wherein the fault detection circuit chain (FDCC) is configured to detect a location of a fault in the test pad chain (TPC) based on a number of clock signals applied to the shift register and a transition time point of a test output signal.

6. The semiconductor device of any one of claims 1 to 5, wherein each of the plurality of fault detection circuits (FDC, FDC1-FDC7) comprises:
a data input circuit (DIC) configured to change a voltage level at a node (ND2) based on a test input signal (TEST _IN) that depends on a fault status of the test pad chain (TPC);
a data path circuit (DPC) configured to store the voltage level at the node (ND2) based on the test input signal; and
a data reset circuit (DRC) connected to the node (ND2) and configured to reset the voltage level at the node (ND2).

7. The semiconductor device of any one of claims 1 to 6, wherein the test pad chain (TPC) comprises a plurality of segments (SEG1- SEG7) distinguished from one another, the plurality of segments being based on connection positions of the plurality of fault detection circuits (FDC, FDC1-FDC7), wherein adjacent fault detection circuits of the plurality of fault detection circuits (FDC, FDC1-FDC7) are respectively connected to a front end and a rear end of a corresponding segment of the plurality of segments (SEG1- SEG7), and wherein adjacent fault detection circuits are configured to detect a fault in the corresponding segment of the plurality of segments (SEG1- SEG7).

8. The semiconductor device of claim 7, wherein each segment of the plurality of segments (SEG1- SEG7) comprises at least one of the first test pads (TP1), and wherein at least one segment of the plurality of segments (SEG1- SEG7) comprises a number of the first test pads different from a number of the first test pads of remaining segments of the plurality of segments (SEG1- SEG7).

9. The semiconductor device of any one of claims 1 to 8, wherein the second structure (200; 400) comprises a cell area (CL) that includes memory cells and a dummy area (DM) adjacent to the cell area (CL), and the first structure (100; 300) comprises a core region (CR) corresponding to the cell area (CL) and a peripheral region (PR) corresponding to the dummy area (DM).

10. The semiconductor device of claim 9, wherein the first test pads (TP1) are in region of the core region (CR) and/or the peripheral region (PR), and the second test pads (TP2) are in the cell area (CL) and/or the dummy area (DM).

11. The semiconductor device of claim 10, wherein the first test pads (TP1) are in the peripheral region (PR), and the second test pads (TP2) are in the dummy area (DM).

12. The semiconductor device of any one of claims 9 to 11, wherein the plurality of fault detection circuits (FDC, FDC1-FDC7) are in the peripheral region (PR) .

13. The semiconductor device of any one of claims 1 to 12, wherein the first structure (100; 300) comprises first connection lines (CNT1) electrically connecting the first test pads (TP1), and the second structure (200; 400) comprises second connection lines (CNT2) electrically connecting the second test pads (TP2).

14. The semiconductor device of claim 13, wherein the first and second connection lines (CNT1, CNT2) are arranged in an alternating fashion along the test pad chain (TPC).

15. The semiconductor device of claim 14, wherein the first test pads (TP1) are sequentially arranged, the second test pads (TP2) are sequentially arranged, and
wherein a first connection line of the first connection lines (CNT1) connects a first-first test pad of the first test pads (TP1) to a second-first test pad of the first test pads (TP1), and a second connection line of the second connection lines (CNT2) connects a second-second test pad of the second test pads (TP2) that corresponds to the second-first test pad to a third-second test pad of the second test pads (TP2).
